# EUROPEAN PATENT SPECIFICATION

(11) **EP 1 639 653 B1**
(45) Date of publication and mention of the grant of the patent: **20.08.2008**
(21) Application number: 03817675.6
(22) Date of filing: 24.06.2003
(51) Int. Cl.: H01L 27/22, H01L 43/08, H01L 43/12

(54) **SELF-ALIGNED CONDUCTIVE LINES FOR FET-BASED MAGNETIC RANDOM ACCESS MEMORY DEVICES AND METHOD OF FORMING THE SAME**
SELBSTAUSGERICHTETE LEITFÄHIGE LINIEN FÜR MAGNETISCHE DIREKTZUGRIFFSSPEICHERBAUSTEINE AUF FET-BASIS UND HERSTELLUNGSVERFAHREN DAFÜR
TRACES CONDUCTEURS AUTO ALIGNES POUR DISPOSITIF MEMOIRE A ACCES DIRECT A BASE DE FET ET PROCEDES DE FABRICATION DE CES TRACES

(43) Date of publication of application: 29.03.2006
(73) Proprietor: International Business Machines Corporation, Armonk, NY 10504 (US)
(72) Inventor: GAIDIS, Michael, C., Wappingers Falls, NY 12590 (US)
(74) Representative: Gascoyne, Belinda Jane
(86) International application number: PCT/US2003/019772
(87) International publication number: WO 2005/010998

(56) References cited:
- EP-A- 1 271 546
- US-A- 5 940 319
- US-A- 6 165 803
- US-B1- 6 191 495
- US-B1- 6 331 943
- US-B1- 6 358 756
- US-B1- 6 365 419
- US-B2- 6 542 398
- TSUJI K ET AL: "0.1 /spl mu/m-rule MRAM development using double-layered hard mask" 2 December 2001 (2001-12-02), INTERNATIONAL ELECTRON DEVICES MEETING 2001. IEDM. TECHNICAL DIGEST. WASHINGTON, DC, DEC. 2 - 5, 2001, NEW YORK, NY : IEEE, US, PAGE(S) 3641-3644 , XP010575243 ISBN: 0-7803-7050-3 * figure 1 *

## Description

### TECHNICAL FIELD

The present invention relates generally to semiconductor device processing and, more particularly, to self-aligned conductive lines for FET-based magnetic random access memory devices and method of forming the same.

### BACKGROUND ART

Magnetic (or magneto-resistive) random access memory (MRAM) is a non-volatile random access memory technology that could potentially replace the dynamic random access memory (DRAM) as the standard memory for computing devices. The use of MRAM as a non-volatile RAM will eventually allow for "instant on" systems that come to life as soon as the system is turned on, thus saving the amount of time needed for a conventional PC, for example, to transfer boot data from a hard disk drive to volatile DRAM during system power up.

A magnetic memory element (also referred to as a tunneling magneto-resistive, or TMR device) includes a structure having ferromagnetic layers separated by a non-magnetic layer (barrier), and arranged into a magnetic tunnel junction (MTJ). Digital information is stored and represented in the memory element as directions of magnetization vectors in the magnetic layers. More specifically, the magnetic moment of one magnetic layer (also referred to as a reference layer) is fixed or pinned, while the magnetic moment of the other magnetic layer (also referred to as a "free" layer) may be switched between the same direction and the opposite direction with respect to the fixed magnetization direction of the reference layer. The orientations of the magnetic moment of the free layer are also known "parallel" and "antiparallel" states, wherein a parallel state refers to the same magnetic alignment of the free and reference layers, while an antiparallel state refers to opposing magnetic alignments therebetween.

Depending upon the magnetic state of the free layer (parallel or antiparallel), the magnetic memory element exhibits two different resistance values in response to a voltage applied across the tunnel junction barrier. The particular resistance of the TMR device thus reflects the magnetization state of the free layer, wherein resistance is "low" when the magnetization is parallel, and "high" when the magnetization is antiparallel. Accordingly, a detection of changes in resistance allows a MRAM device to provide information stored in the magnetic memory element (i.e., a read operation). In addition, a MRAM cell is written to through the application a bi-directional current in a particular direction, in order to magnetically align the free layer in a parallel or antiparallel state.

A practical MRAM device may have, for example, a cross point cell (XPC) configuration, in which each cell is located at the crossing point between parallel conductive wordlines in one horizontal plane and perpendicularly running sense lines in another horizontal plane. This particular configuration is advantageous in that the layout of the cells helps to increase the array cell density of the device. However, one difficulty associated with the practical operation of a cross-point MRAM array relates to the sensing of a particular cell, given that each cell in the array is coupled to the other cells through several parallel leakage paths. The resistance seen at one cross point equals the resistance of the memory cell at that cross point in parallel with resistances of memory cells in the other rows and columns, and thus can be difficult to accurately measure.

Accordingly, MRAM devices are also fabricated with a field effect transistor (FET) based configuration. In the FET-based configuration, each MRAM cell includes an access transistor associated therewith, in addition to an MTJ. By keeping the access transistors to cells not being read in a non-conductive state, parasitic device current is prevented from flowing through those other cells. The tradeoff with the FET-based configuration versus the XPC-based configuration is the area penalty associated with the location of the access transistors and additional metallization lines.

In a conventionally formed FET-based MRAM device, the MTJ is typically formed over a conductive metal strap that laterally connects the bottom of the MTJ to the access FET (through a via, metallization line and contact area stud). In addition, a relatively thick layer of metal hardmask is formed on the top of the MTJ such that a trench etching step may be used to form the upper metallization layer for connection to the cell. If the metal hardmask is too thin, the formation of the trench for the upper metallization layer could also end up exposing the metal strap (through a phenomenon such as "microtrenching", for example). This would in turn cause the subsequently formed upper metallization material fill to contact the metal strap, thus shorting across the MTJ and ruining the memory element. On the other hand, having too thick a hardmask will increase the distance between the upper metallization layer and the MTJ, thereby increasing the level of current needed to generate the magnetic field for switching the state of the magnetic memory element.

Because of the continuing trend of decreasing device ground rules and smaller wiring sizes, it is therefore desirable to be able to bring the upper metallization level of an FET-based MRAM device closer to the MTJ element, but without increasing the risk of shorting the upper metallization level to the metal strap portion of the device.

### DISCLOSURE OF INVENTION

The foregoing discussed drawbacks and deficiencies of the prior art are overcome or alleviated by a self-aligned, protective conductive line structure for a field effect transistor (FET) based magnetic random access memory (MRAM) device including a lateral metal strap conductively coupled to a lower metallization line. A magnetic tunnel junction (MTJ) stack is formed on the metal strap, and a metal shield is formed over the MTJ stack, the metal shield being self aligned with respect to the metal strap. An upper metallization line is conductively coupled to the metal shield, wherein the metal shield serves as an etch stop during the formation of the upper metallization line.

### BRIEF DESCRIPTION OF THE DRAWINGS

Referring to the exemplary drawings wherein like elements are numbered alike in the several Figures:
Figure 1 is a cross sectional view of a conventionally formed, FET-based MRAM device;
Figure 2 is a detailed view of the formation of an upper metallization level trench of the MRAM device of Figure 1, particularly illustrating "microtrenching" phenomenon; and
Figures 3(a) through 3(f) illustrate an exemplary process for forming an FET-based magnetic random access memory device having self aligned conductive lines, in accordance with an embodiment of the invention.

### BEST MODE OF CARRYING OUT THE INVENTION

Disclosed herein is a method of forming an FET-based magnetic memory device, in which a self aligned metal shield is formed in conjunction with a conductive strap located at the bottom of the magnetic memory element. Again, the metal strap is used to couple the memory element to an access transistor disposed beneath the element. The metal shield thus provides protection for the strap during later processing steps, particularly that step in which an upper metallization trench is etched for contacting the top of the magnetic memory element. Such protection prevents shorting of the memory element, as well as provides the additional benefit of allowing the upper metallization wires to be formed closer to the top memory element. This further results in relaxed requirements with respect to the amount of current needed to switch the memory element.

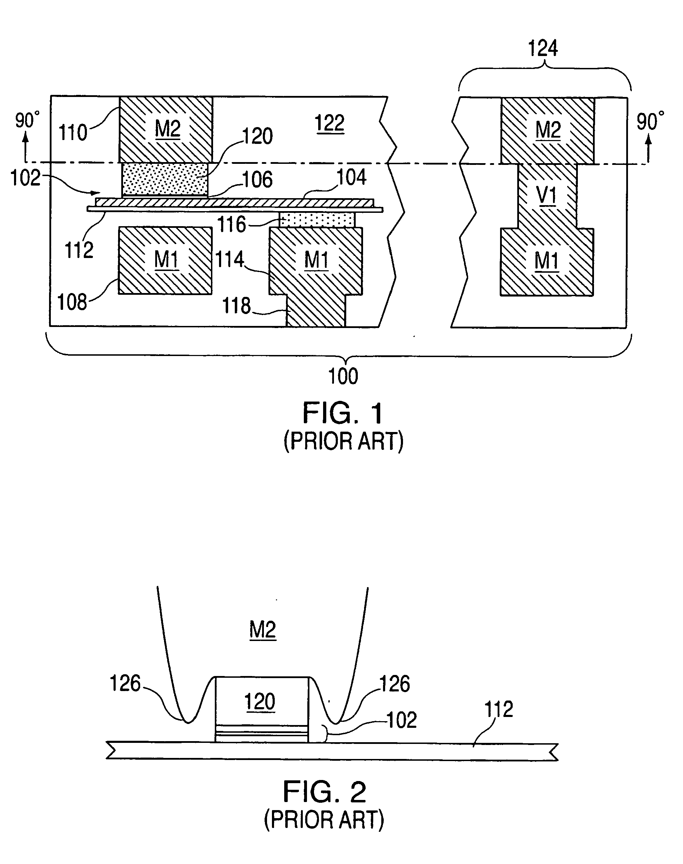

Referring initially to Figure 1, there is shown a cross sectional view of a conventionally formed, FET-based MRAM device 100. More specifically, Figure 1 illustrates a portion of an FET-based memory element 102 disposed between a lower metallization level and an upper metallization level. In the example depicted, the lower metallization level corresponds to the first metallization level (M1) of the MRAM device 100, while the upper metallization level corresponds to the second metallization level (M2) of the MRAM device 100. However, one skilled in the art will recognize that the individual memory elements could also be formed between other layers within the device 100 (e.g., between M2 and M3).

As is shown in Figure 1, the memory element 102 includes an MTJ stack having a lower magnetic layer 104 with a non-magnetic layer (e.g., an oxide) and upper magnetic layer formed thereatop (shown collectively as layer 106). Although the cell 102 is located at a corresponding intersection between a wordline 108 and a bitline 110, the bottom portion of the cell 102 is not in direct electrical contact with wordline 108, unlike the XPC configuration. Instead, the cell 102 is formed atop metal strap 112, which serves to interconnect the cell 102 to lower level metallization line 114 through via stud 116. In turn, line 114 completes the connection of the cell 102 to an associated substrate-level access transistor (not shown) through contact area stud 118.

As indicated previously, the conventional FET-based cell configuration of Figure 1 provides for a relatively thick metal hardmask 120 (e.g., on the order of about 1700 angstroms (Å, 1 Å= 0.1 nm)) that serves as an interconnect between bitline 110 and the top layer of cell 102. The remaining areas of device 100, generally indicated at 122, represent insulating (e.g., dielectric) layers for interlevel isolation. It should be noted at this point that the M2 level of the device 100 shown in Figure 1 (that is, the portion of the figure above the dashed line) has been rotated by 90° for purposes of illustration, which will become more apparent hereinafter. One skilled in the art will recognize that, since the metallization lines at M1 and M2 are orthogonal to one another, the bitline 110 at M2 would actually be disposed horizontally along the top of Figure 1. In addition, Figure 1 also illustrates a periphery region 124 of device 100, in order to illustrate the relationship between lower metallization level M1, upper metallization level M2, and connecting via stud V1.

As also described previously, the existing methodology utilizes a relatively large thickness for the metal hardmask 120 on top of the TJ element, such that a timed trench etch can be used to define the M2 bitline 100. The etch is intended to terminate after reaching the metal hardmask 120, but before the metal strap 112 is exposed. With the ever increasing desire for device miniaturization and power reduction, a decreased wiring size results in a corresponding need to reduce the distance between the bitline and the MTJ stack. However, as a result of unavoidable etch nonuniformities and the microtrenching effect, the M2 level cannot be brought arbitrarily close to the top of the MTJ stack without the risk of shorting to the metal strap. The microtrenching effect is illustrated in Figure 2. It is believed that, during the etching process for the M2 trench formation, the outer edges thereof receive relatively greater ion bombardment due charging effects along the edges. Thus, the additional etching at the outer edges 126 of the M2 trench (extending beyond the outer edges of hardmask 120) result in an irregular trench shape in which there is less clearance between M2 and the metal strap 112 at the outer edges. As such, a significant reduction in the thickness of the hardmask 120 increases the risk of a device short.

Therefore, in accordance with an embodiment of the invention, there is disclosed an FET-based magnetic random access memory device having self-aligned conductive lines such that an additional metal hardmask formed above the memory element has the same shape as the metal strap beneath the memory element. The metal hardmask thereby serves as a shield that prevents the M2 trench formation from reaching a depth below the top of the memory element and shorting to the metal strap. Accordingly, the metal shield allows for the formation of a much thinner MTJ metal hard mask and concomitant reduction of the distance between M2 and the MTJ, thus resulting in a higher magnetic field strength for a given amount of bitline current. In addition, the process allows for better pattern transfer fidelity with regard to the MTJ hardmask etching because a thinner hardmask is used.

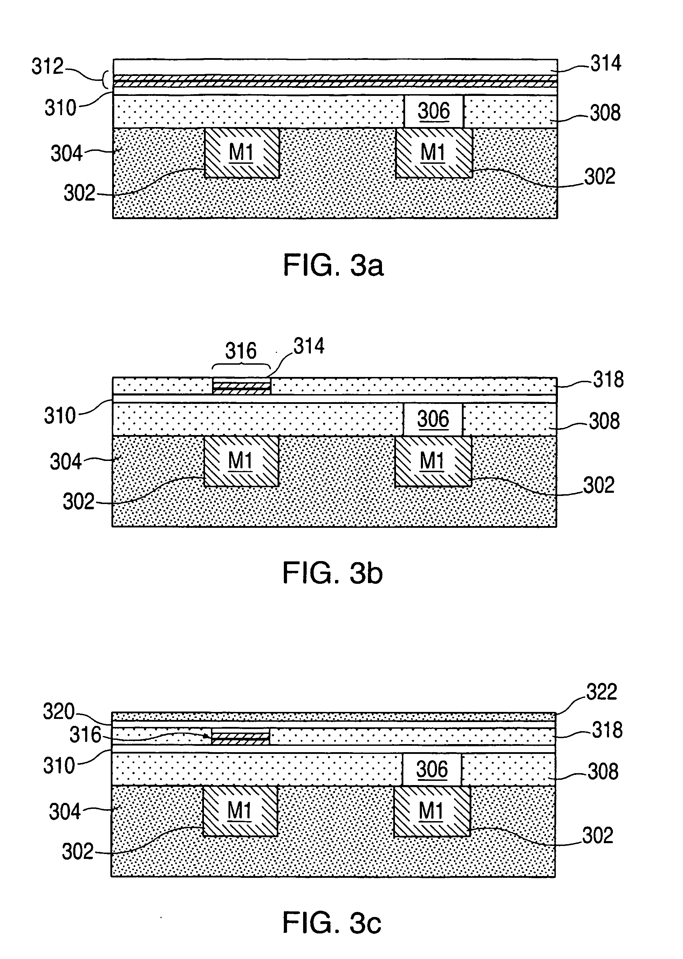

An exemplary processing sequence is illustrated in Figures 3(a) through 3(f). For purposes of simplicity, the FET and other associated vias/connections below the M1 metallization level are omitted. Generally speaking, the processing steps in forming the device up to the partially completed structure shown in Figure 3(a) may be produced in accordance with conventional techniques. In particular, the lines formed at the M1 level of metallization are preferably comprised of copper filled trenches 302 defined in a dielectric 304 such as silicon dioxide. In addition, a metal strap via 306 is formed in another dielectric 308 through a metal damascene process.

First, an underlayer of metal 310 used in the formation of the metal strap. Then, the active magnetic stack materials (denoted collectively by 312) are deposited on the metal underlayer 310, followed by a conducting hardmask capping layer 314. In a preferred embodiment, the strap metal underlayer and hardmask capping layer are tantalum (Ta) or tantalum nitride (TaN) based materials. However, other similar suitable materials such as titanium nitride (TiN), tungsten (W), platinum (Pt), and the like, may also be used. In addition, the initial thickness of the hardmask capping layer 314 is preferably selected at about 500 Å, although this may be adjusted to be within a range of about 100 Å to about 1500 Å, depending on the particular needs of the specific memory element design. It should be noted that the existing device process typically utilizes a very thick metal hardmask capping layer (e.g., about 1700 Å).

The exemplary process flow embodiment of the present invention process flow deviates from the conventional processing in a manner shown in Figure 3(b). A photoresist (not shown) (or photoresist plus a suitable hardmask) is used to define the tunnel junction 316 by etching through the capping layer 314 and the magnetic stack layers 312, but not through the strap metal underlayer 310. This photolithography and etching step thus defines a memory element in a region suitable for switching by magnetic fields from the associated M1 and M2 wires (i.e., the wordline and bitline). Because the present invention embodiment uses a relatively thin metal hardmask capping layer 314, the memory element definition etch is much simpler, thereby allowing a greater fidelity in pattern transfer. After the etch through the magnetic layers 312, a dielectric film 318 is deposited to encapsulate the tunnel junction memory element 316.

Considerable flexibility is contemplated with regard to the choice of dielectric materials for the dielectric film 318 (e.g., silicon nitride, silicon oxide, silicon carbide, low-K materials, etc.), so long as the dielectric is suitable for a subsequent polish by chemical-mechanical planarization (CMP) or planarization by etchback. Thus, a dielectric material may be chosen that optimizes the performance of the memory element, as opposed to concerns with process compatibility. After the dielectric deposition, a CMP step is used to polish away the dielectric atop the tunnel junction metal hardmask 314, leaving (for example) only about 200 Å of the original 500 Å of hardmask thickness. In alternative embodiments, (with different metal hardmask materials and thicknesses), the remaining thickness may vary depending on the effectiveness of the CMP. It will be appreciated, however, that the choice of metal hardmask material and thickness is not a significant issue with regard to the success of the process flow, and affects device performance only to the extent of the spacing that ultimately results between the subsequently formed M2 wire and the memory element.

As shown in Figure 3(c), the CMP polish step is followed by the deposition of a metal "shield" layer 320, and well as any appropriate hardmask layers 322 used for subsequent patterning of the shield layer 320. In a preferred embodiment, the shield layer 320 is also Ta or TaN, with a thickness of about 200 A. However, alternative embodiments may utilize other materials and thicknesses for the shield material, so long as they can be readily etched yet also serve as suitable etch stops when in , environments tailored for etching dielectric materials such as silicon oxide, silicon nitride, low-K materials, etc. Again, it is desirable to be able to keep the thickness of the shield layer 320 to a minimum, as this will affect the distance between the M2 wire and the memory element. As also illustrated in Figure 3(c), a dielectric film 322 of suitable thickness may be used as a hardmask on top of the shield layer 320, if photoresist is not suitable alone.

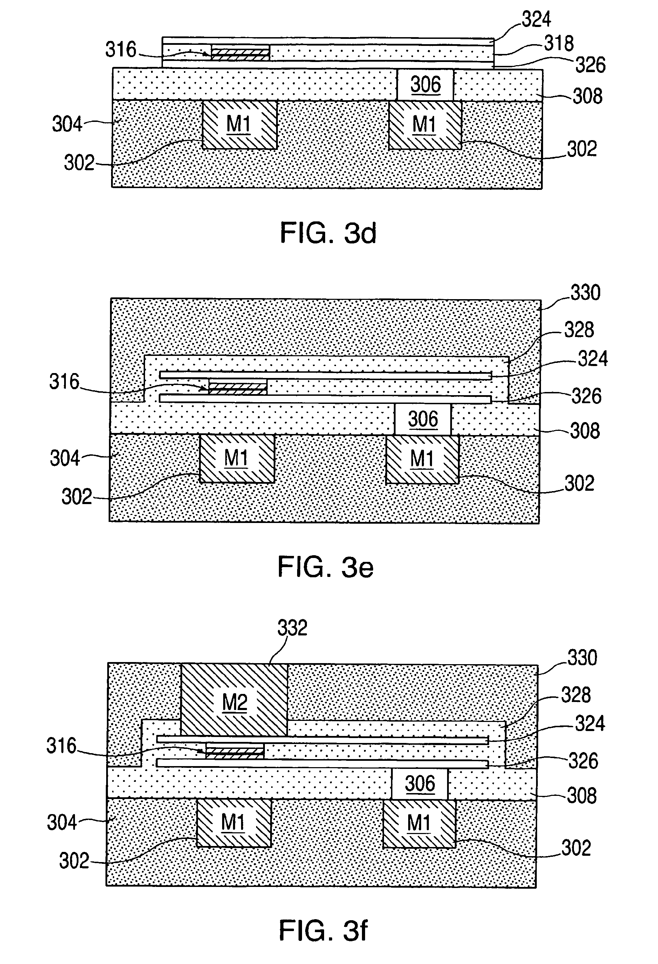

Referring now to Figure 3(d), following the deposition of the shield and mask layers, the shape of the metal strap is patterned through the shield layer material 320, the intermediate dielectric 318, and the strap metal underlayer material 310, in a self-aligned fashion that keeps the resulting metal shield 324 overlapped with the lateral metal strap 326. Although this patterning is generally implemented through reactive ion etching, it could be accomplished through other techniques such as wet chemical etching or ion milling, for example. After the strap patterning etching step, a wet chemical etch clean or other suitable dry chemical etch clean can be performed without damage to the tunnel junction memory element. Since the memory element is completely encapsulated at this point, it will not degrade as the result of any chemical cleans that may be applied in order to improve adhesion of subsequent layers to be deposited.

As shown in Figure 3(e), if necessary, an additional layer of encapsulating adhesive dielectric 328 is formed over the top of the shield 324 (and along the sides of the shield 324 and strap 326). Then, an upper metallization (M2) level dielectric 330 is deposited, which may include for example silicon nitride, silicon oxide, silicon carbide, low-K materials, etc., or multilayers comprising one or more of such materials. Following deposition of the M2 level dielectric, a CMP step is performed to planarize the top surface thereof down to a suitable distance from the top of the shield 324. This distance is generally determined by the initial choice of M2 dielectric thickness and the CMP polish time, and will thus result in automatic definition of the M2 metal thickness.

Finally, Figure 3(f) illustrates the formation and fill of the M2 metal trench (i.e., the formation of the cell bitline), wherein the bitline 332 makes contact to the top of the memory element 316 through the conductive shield 324. Again, for purposes of illustration, the M2 trench is shown rotated 90 degrees with respect to the lower device levels. It will be appreciated that the distance between the bitline 332 and the top of the memory element stack 316 is defined by the thickness of the TaN tunnel junction hardmask 314 atop stack 316, and the thickness of the shield 324. Since in the illustrated embodiment, the total thickness of the hardmask 314 and the shield 324 is on the order of about 400 to about 500 Å, the bitline 332 is disposed relatively close to the memory element 316, thereby facilitating low-current writing of the memory element. Moreover, since the shield 324 serves as an etch stop for the M2 trench, the deposition of the M2 fill does not shunt the memory element stack 316 by contacting the strap 326.

It will thus be appreciated that the use of the protective upper shield metal facilitates the etching of the M2 trench in the dielectric 330 with a well-defined etch stop at a set distance above the metal strap 326. Through appropriate selection of metal shield materials, M2-level dielectrics, and RIE process parameters, an extremely high selectivity between the dielectric and the metal shield may be achieved, such that the M2 trench etch stops sharply on the thin shield metal. The M2 trench may then be filled in with metal (for example, through a copper damascene technique), thereby resulting in the self aligned structure such as that shown in Figure 3(f). In addition, the process enhances the pattern transfer fidelity when etching the magnetic memory element, in that it allows the use of thinner mask materials. The improved pattern transfer results in improved uniformity for the array of memory elements, and thereby improves yield and allows scaling to smaller dimensions.

Although the formation of V1 vias have not been described in exemplary process flow, they may be easily added through the use of existing techniques known to those skilled in the art. Again, prior to the addition of metal in the M2 trenches (and any V1 vias), a wet or dry chemical cleaning step may be added to improve contact reliability and conductivity. Because the shield structure 324 completely covers the tunnel junction stack 316 and any sidewall residue that may form during the MTJ etch, the shield structure 324 effectively protects the tunnel junction stack 316 from degradation during the cleaning step.

It should also be appreciated that the memory element may be placed at locations other than between the M1 and M2 levels with respect to the silicon surface. As such, the use of the terminology "M1" and "M2" is not intended to restrict the memory element to locations between the first and second wiring levels above the silicon surface.

While the exemplary embodiment disclosed above is presented with respect to the problem of shunted magnetic memory elements, it is also contemplated that the principles described herein are also applicable to other semiconductor devices that require contact from above such as diodes, ferroelectric memories and ovonics, to name a few. Furthermore, although the exemplary embodiment describes a lateral metal strap that extends horizontally to connect to a via not directly below the memory element, the above process flow is also applicable to devices wherein a via is included directly beneath the memory element.

While the invention has been described with reference to a preferred embodiment or embodiments, it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment disclosed as the best mode contemplated for carrying out this invention, but that the invention will include all embodiments falling within the scope of the appended claims.

### INDUSTRIAL APPLICABILITY

The present disclosure has industrial applicability in the area of semiconductor device processing and, in particular, to the formation of semiconductor memory devices such as magnetic random access memory (MRAM).

## Claims

1. A conductive line structure for a field effect transistor (FET) based magnetic random access memory (MRAM) device, comprising:
a magnetic tunnel junction (MTJ) stack (102,316) formed on a metal strap (112,326) which extends laterally from the bottom of the MTJ stack to conductively couple the MTJ stack to a lower metallization line (114,302);
a metal shield (324) formed over said MTJ stack (102,316), said metal shield (324) being same shape as, and self-aligned with respect to, said metal strap (112,326); and
an upper metallization line (110,332) conductively coupled to said metal shield (324), wherein said metal shield (324) serves as an etch stop during the formation of said upper metallization line (110,332).

2. The structure of claim 1, wherein said MTJ stack (316) further comprises:
a non-magnetic layer formed between a lower magnetic layer (104) and an upper magnetic layer (106); and
a metal hardmask layer (120,314) formed on said upper magnetic layer (106);
wherein the distance between said upper metallization line (110,322) and said upper magnetic layer (106) is defined by a total thickness of said metal hardmask layer (120,314) and said metal shield (324).

3. A structure according to claim 2, wherein the total thickness of said hardmask layer and said metal shield is about 40 to about 50 nm (400 to about 500 angstroms)

4. A structure according to claim 1, 2 or 3, wherein said metal shield or said metal hardmask layer comprise one of: tantalum, tantalum nitride, titanium nitride, tungsten, platinum, and combinations comprising at least one of the foregoing.

5. A structure according to any preceding claim, wherein: said lower metallization line is formed at a first metallization level (M1) of the MRAM device, and said upper metallization level is formed at a second metallization level (M2) of the MRAM device.

6. A structure according to any preceding claim, further comprising:
a wordline formed at a lower metallization level (M1) and adjacent said lower metallization line, said wordline electrically insulated from said lateral metal strap, and said wordline disposed below said MTJ stack;
wherein said upper metallization line comprises a bitline of an individual MRAM cell, said cell also including said MTJ stack and said wordline.

7. A method for forming the conductive line structure of any preceding claim, the method comprising: forming a magnetic stack layer (312) over a metal underlayer (310), said metal underlayer (310) in conductive contact with said lower metallization line (302); forming a metal hardmask layer (314) over said magnetic stack layer (312);
patterning said magnetic stack layer (312) and said metal hardmask layer (314) so as to form said magnetic tunnel junction (MTJ) stack (102,316);
encapsulating said MTJ stack (102,316) with dielectric material (318) and planarizing said dielectric material (318) to said metal hardmask (120,314);
forming a metal shield layer (320) over said dielectric material and said metal hardmask (314);
patterning both said metal shield layer (320) and said metal underlayer (310) so as to form said self-aligned metal shield (324) and metal strap (326); and
forming said upper metallization line (332) on said metal shield (324), wherein said metal shield (324) serves as an etch stop during the formation of said upper metallization line (332).

8. The method of claim 7, wherein said metal hardmask layer (314) is planarized to a thickness of about 20 nm (200 angstroms) prior to the formation of the metal shield layer (320) thereupon.

9. The method of claim 7 or 8, wherein said MTJ stack (316) further comprises:
a non-magnetic layer formed between a lower magnetic layer (104) and an upper magnetic layer (106); and
said metal hardmask layer (314) formed on said upper magnetic layer (306) ;
wherein the distance between said upper metallization line (322) and said upper magnetic layer (106) is defined by a total thickness of said metal hardmask layer (314) and said metal shield (324).

10. The method of claim 9, wherein said total thickness of said metal hardmask layer (314) and said metal shield (324) is about 40 to about 50 nm (400 to about 500 angstroms).

11. The method of claim 10, wherein said metal hardmask layer (314) is deposited at an initial thickness of about 50 nm (500 angstroms) prior to planarization thereof.

12. The method of any of claims 7 to 11, wherein said metal shield layer (320) comprises one of: tantalum, tantalum nitride, titanium nitride, tungsten, platinum, and combinations comprising at least one of the foregoing.

13. The method of any of claims 7 to 12, further comprising:
following said patterning of said metal shield layer (320) and said metal underlayer (310), encapsulating said self-aligned metal shield (324) and said metal strap (326) with an encapsulating dielectric (308); and
depositing an upper metallization level dielectric (330) over said encapsulating dielectric (308).

14. The method of any of claims 7 to 13, wherein said conductive contact between said metal underlayer (310) and a lower metallization line (302) is formed by a metal strap via (306).

## Patentansprüche

1. Leitungsstruktur für eine magnetische Direktzugriffsspeicher(MRAM)-Einheit auf Feldeffekttransistor(FET)-Basis, welche das Folgende umfasst:
einen Magnettunnelübergangs (MTJ) -Stapel (102, 316), der auf einer Metallbrücke (112, 326) ausgebildet ist, welche sich vom Boden des MTJ-Stapels aus zur Seite erstreckt, um den MTJ-Stapel leitend mit einer unteren Metallisierungsleitung (114, 302) zu verbinden;
eine Metallabschirmung (324), welche über dem MTJ-Stapel (102, 316) ausgebildet ist, wobei die Metallabschirmung (324) dieselbe Form wie die Metallbrücke (112, 326) aufweist und bezüglich dieser selbstausgerichtet ist; und
eine obere Metallisierungsleitung (110, 332), welche leitend mit der Metallabschirmung (324) verbunden ist, wobei die Metallabschirmung (324) während der Bildung der oberen Metallisierungsleitung (110, 332) als Ätzstopp dient.

2. Struktur nach Anspruch 1, wobei der MTJ-Stapel (316) ferner das Folgende umfasst:
eine nichtmagnetische Schicht, welche zwischen einer unteren magnetischen Schicht (104) und einer oberen magnetischen Schicht (106) ausgebildet ist; und
eine Metall-Hartmaskenschicht (120, 314), welche auf der oberen magnetischen Schicht (106) ausgebildet ist;
wobei der Abstand zwischen der oberen Metallisierungsleitung (110, 322) und der oberen magnetischen Schicht (106) durch eine Gesamtdicke der Metall-Hartmaskenschicht (120, 314) und der Metallabschirmung (324) definiert ist.

3. Struktur nach Anspruch 2, wobei die Gesamtdicke der Hartmaskenschicht und der Metallabschirmung etwa 40 bis etwa 50 nm (etwa 400 bis etwa 500 Ängström) beträgt.

4. Struktur nach Anspruch 1, 2 oder 3, wobei die Metallabschirmung oder die Metall-Hartmaskenschicht eines aus dem Folgenden umfasst: Tantal, Tantalnitrid, Titannitrid, Wolfram, Platin und Kombinationen, welche mindestens eines der vorstehenden Materialien umfassen.

5. Struktur nach einem der vorhergehenden Ansprüche, wobei:
die untere Metallisierungsleitung auf einer ersten Metallisierungsebene (M1) der MRAM-Einheit ausgebildet ist und die obere Metallisierungsleitung auf einer zweiten Metallisierungsebene (M2) der MRAM-Einheit ausgebildet ist.

6. Struktur nach einem der vorhergehenden Ansprüche, welche ferner das Folgende umfasst:
eine Wortleitung, welche auf einer unteren Metallisierungsebene (M1) und in Nachbarschaft zu der unteren Metallisierungsleitung ausgebildet ist, wobei die Wortleitung von der seitlichen Metallbrücke elektrisch isoliert ist und die Wortleitung unter dem MTJ-Stapel angeordnet ist;
wobei die obere Metallisierungsleitung eine Bitleitung einer einzelnen MRAM-Zelle umfasst, wobei die Zelle auch den MTJ-Stapel und die Wortleitung umfasst.

7. Verfahren zum Bilden der Leitungsstruktur eines der vorhergehenden Ansprüche, wobei das Verfahren das Folgende umfasst: Bilden einer magnetischen Stapelschicht (312) über einer Metall-Unterschicht (310), wobei die Metall-Unterschicht (310) in leitendem Kontakt mit der unteren Metallisierungsleitung (302) steht; Bilden einer Metall-Hartmaskenschicht (314) über der magnetischen Stapelschicht (312);
Strukturieren der magnetischen Stapelschicht (312) und der Metall-Hartmaskenschicht (314), um den Magnettunnelübergangs (MTJ) -Stapel (102, 316) zu bilden;
Verkapseln des MTJ-Stapels (102, 316) mit dielektrischem Material (318) und Planarisieren des dielektrischen Materials (318) bis zu der Metall-Hartmaske (120, 314);
Bilden einer Metallabschirmungsschicht (320) über dem dielektrischen Material und der Metall-Hartmaske (314);
Strukturieren sowohl der Metallabschirmungsschicht (320) als auch der Metall-Unterschicht (310), um die selbstausgerichtete Metallabschirmung (324) und die Metallbrücke (326) zu bilden; und
Bilden der oberen Metallisierungsleitung (332) auf der Metallabschirmung (324), wobei die Metallabschirmung (324) während der Bildung der oberen Metallisierungsleitung (332) als Ätzstopp dient.

8. Verfahren nach Anspruch 7, wobei die Metall-Hartmaskenschicht (314) vor der Bildung der Metallabschirmungsschicht (320) darauf auf eine Dicke von etwa 20 nm (200 Ängström) planarisiert wird.

9. Verfahren nach Anspruch 7 oder 8, wobei der MTJ-Stapel (316) ferner das Folgende umfasst:
eine nichtmagnetische Schicht, welche zwischen einer unteren magnetischen Schicht (104) und einer oberen magnetischen Schicht (106) ausgebildet ist; und
die Metall-Hartmaskenschicht (314), welche auf der oberen magnetischen Schicht (106) ausgebildet ist;
wobei der Abstand zwischen der oberen Metallisierungsleitung (322) und der oberen magnetischen Schicht (106) durch eine Gesamtdicke der Metall-Hartmaskenschicht (314) und der Metallabschirmung (324) definiert ist.

10. Verfahren nach Anspruch 9, wobei die Gesamtdicke der Metall-Hartmaskenschicht (314) und der Metallabschirmung (324) etwa 40 bis etwa 50 nm (etwa 400 bis etwa 500 Ängström) beträgt.

11. Verfahren nach Anspruch 10, wobei die Metall-Hartmaskenschicht (314) vor ihrer Planarisierung mit einer anfänglichen Dicke von etwa 50 nm (500 Ängström) abgeschieden wird.

12. Verfahren nach einem der Ansprüche 7 bis 11, wobei die Metall-Abschirmungsschicht (320) eines aus dem Folgenden umfasst: Tantal, Tantalnitrid, Titannitrid, Wolfram, Platin und Kombinationen, welche mindestens eines der vorstehenden Materialien umfassen.

13. Verfahren nach einem der Ansprüche 7 bis 12, welches ferner das Folgende umfasst:
Verkapseln der selbstausgerichteten Metallabschirmung (324) und der Metallbrücke (326) mit einem Verkapselungs-Dielektrikum (308) nach der Strukturierung der Metall-Abschirmungsschicht (320) und der Metall-Unterschicht (310) ; und
Abscheiden eines Dielektrikums (330) der oberen Metallisierungsebene über dem Verkapselungs-Dielektrikum (308) .

14. Verfahren nach einem der Ansprüche 7 bis 13, wobei der leitende Kontakt zwischen der Metall-Unterschicht (310) und einer unteren Metallisierungsleitung (302) durch eine Metallbrücken-Durchkontaktierung (306) gebildet wird.

## Revendications

1. Structure de lignes conductrice pour un dispositif de mémoire vive magnétique (MRAM) fondé sur un transistor à effet de champ (FET), comprenant :
un empilement de jonctions à effet tunnel magnétique (MTJ) (102, 316) formé sur une connexion métallique (112, 326) qui s'étend latéralement par rapport à la partie inférieure de l'empilement de jonctions MTJ pour coupler de manière conductrice l'empilement de jonctions MTJ avec une ligne de métallisation inférieure (114, 302),
un blindage métallique (324) formé sur ledit empilement de jonctions MTJ (102, 316), ledit blindage métallique (324) ayant la même forme que ladite connexion métallique (112, 326) et étant aligné par rapport à celle-ci, et
une ligne de métallisation supérieure (110, 332) couplée de manière conductrice audit blindage métallique (324), où ledit blindage métallique (324) sert d'arrêt de gravure au cours de la formation de ladite ligne de métallisation supérieure (110, 332).

2. Structure selon la revendication 1, dans lequel ledit empilement de jonctions MTJ (316) comprend en outre :
une couche non magnétique formée entre une couche magnétique inférieure (104) et une couche magnétique supérieure (106), et
une couche de masque dur métallique (120, 314) formée sur ladite couche magnétique supérieure (106),
où la distance entre ladite ligne de métallisation supérieure (110, 322) et ladite couche magnétique supérieure (106) est définie par l'épaisseur totale de ladite couche de masque dur métallique (120, 314) et dudit blindage métallique (324).

3. Structure selon la revendication 2, dans laquelle l'épaisseur totale de ladite couche de masque dur et dudit blindage métallique est d'environ 40 à environ 50 nm (400 à environ 500 angströms).

4. Structure selon la revendication 1, 2 ou 3, dans laquelle ledit blindage métallique ou ladite couche de masque dur métallique comprend un élément parmi : le tantale, le nitrure de tantale, le nitrure de titane, le tungstène, le platine et des combinaisons comprenant au moins l'un de ceux qui précèdent.

5. Structure selon l'une quelconque des revendications précédentes, dans laquelle ladite ligne de métallisation inférieure est formée à un premier niveau de métallisation (M1) du dispositif de mémoire MRAM, et ledit niveau de métallisation supérieur est formé à un deuxième niveau de métallisation (M2) du dispositif de mémoire MRAM.

6. Structure selon l'une quelconque des revendications précédentes, comprenant en outre :
une ligne de mots formée à un niveau de métallisation inférieur (M1) et adjacente à ladite ligne de métallisation inférieure, ladite ligne de mots étant électriquement isolée de ladite connexion métallique latérale, et ladite ligne de mots étant disposée au-dessous dudit empilement de jonctions MTJ,
où ladite ligne de métallisation supérieure comprend une ligne de bits constituée d'une cellule de mémoire MRAM individuelle, ladite cellule comprenant également ledit empilement de jonctions MTJ et ladite ligne de mots.

7. Procédé de formation de la structure de lignes conductrices selon l'une quelconque des revendications précédentes, le procédé comprenant les étapes consistant à : former une couche d'empilement magnétique (312) sur une sous-couche métallique (310), ladite sous-couche métallique (310) étant en contact conducteur avec ladite ligne de métallisation inférieure (302), former une couche de masque dur métallique (314) sur ladite couche d'empilement magnétique (312),
doter d'un motif ladite couche d'empilement magnétique (312) et ladite couche de masque dur métallique (314) de manière à former ledit empilement de jonctions à effet tunnel magnétique (MTJ) (102, 316),
encapsuler ledit empilement de jonctions MTJ (102, 316) avec un matériau diélectrique (318) et aplanir ledit matériau diélectrique (318) sur ledit masque dur métallique (120, 314),
former une couche de blindage métallique (320) sur ledit matériau diélectrique et sur ledit masque dur métallique (314),
doter d'un motif à la fois ladite couche de blindage métallique (320) et ladite sous-couche métallique (310) de manière à former un blindage métallique auto-aligné (324) et une connexion métallique (326), et
former ladite ligne de métallisation supérieure (332) sur ledit blindage métallique (324), où ledit blindage métallique (324) sert d'arrêt de gravure au cours de la formation de ladite ligne de métallisation supérieure (332).

8. Procédé selon la revendication 7, dans lequel ladite couche de masque dur métallique (314) est aplanie à une épaisseur d'environ 20 nm (200 angströms) avant la formation de la couche de blindage métallique (320) sur celle-ci.

9. Procédé selon la revendication 7 ou 8, dans lequel ledit empilement de jonctions MTJ (316) comprend en outre :
une couche non magnétique formée entre une couche magnétique inférieure (104) et une couche magnétique supérieure (106), et
ladite couche de masque dur métallique (314) formée sur ladite couche magnétique supérieure (306),
où la distance entre ladite ligne de métallisation supérieure (322) et ladite couche magnétique supérieure (106) est définie par l'épaisseur totale de ladite couche de masque dur métallique (314) et dudit blindage métallique (324).

10. Procédé selon la revendication 9, dans lequel ladite épaisseur totale de ladite couche de masque dur métallique (314) et dudit blindage métallique (324) est d'environ 40 à environ 50 nm (400 à environ 500 angströms).

11. Procédé selon la revendication 10, dans lequel ladite couche de masque dur métallique (314) est déposée à une épaisseur initiale d'environ 50 nm (500 angströms) avant son aplanissement.

12. Procédé selon l'une quelconque des revendications 7 à 11, dans lequel ladite couche de blindage métallique (320) comprend un élément parmi : le tantale, le nitrure de tantale, le nitrure de titane, le tungstène, le platine et des combinaisons comprenant au moins l'un des éléments précédents.

13. Procédé selon l'une quelconque des revendications 7 à 12, comprenant en outre les étapes consistant à :
suivre la mise en motif de ladite couche de blindage métallique (320) et de ladite sous-couche métallique (310), encapsuler ledit blindage métallique auto-aligné (324) et ladite connexion métallique (326) avec un diélectrique d'encapsulation (308), et
déposer un diélectrique de niveau de métallisation supérieur (330) sur ledit diélectrique d'encapsulation (308).

14. Procédé selon l'une quelconque des revendications 7 à 13, dans lequel ledit contact conducteur entre ladite sous-couche métallique (310) et une ligne de métallisation inférieure (302) est formé par une traversée de connexion métallique (306).
